# EUROPEAN PATENT APPLICATION

(11) **EP 4 826 763 A1**
(43) Date of publication of application: **21.10.2026**
(21) Application number: 25171465.5
(22) Date of filing: 18.04.2025
(51) Int. Cl.: H01L 21/67, H01L 21/683

(54) **SUBSTRATE CLAMP EXCHANGER**

(71) Applicant: ASML Netherlands B.V., 5500 AH Veldhoven (NL)
(72) Inventor: SEIJGER, Olav, Johannes, 5500 AH Veldhoven (NL); RENKENS, Michael, Jozefa, Mathijs, 5500 AH Veldhoven (NL); KNOL, Joris, Lodewijk, 5500 AH Veldhoven (NL); PELLEMANS, Henricus, Petrus, Maria, 5500 AH Veldhoven (NL)
(74) Representative: ASML Netherlands B.V.

(57) **Abstract**

A substrate clamp exchanger, configured to exchange substrate clamps of a support stage configured to move substrates, comprises: a substrate clamp carrier configured to carry at least one replacement substrate clamp; and a picker configured to automatically pick from the substrate clamp carrier a replacement substrate clamp for attaching to the support stage.

## Description

### TECHNICAL FIELD

The present disclosure relates generally to a substrate clamp exchanger, a bonding tool, a method for exchanging substrate clamps and a method for bonding.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die - where these specific portions which may be aligned in three-dimensional space to ensure functional connectivity. Alignment of these die, which may have multiple fabrication layers, different critical dimensions, different nodes, packaging, etc., with each other may require different techniques than used for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another.

In the context of semiconductor manufacture, improvements in a bonding process (e.g., improvements in heterogeneous integration) lead to improvements in IC manufacturing and integration abilities. In a bonding process, dies or substrates are to be transferred from a donor substrate onto a stage or acceptor substrate. In order to pick dies off a donor substrate and transfer the dies, die clamps may be used. Such die clamps may degrade over time and may need to be replaced in order to maintain the accuracy of the bonding process. It is desirable to reduce the any reduction in throughput associated with replacement of the die clamps.

### SUMMARY

According to an embodiment, there is provided a substrate clamp exchanger configured to exchange substrate clamps of a support stage configured to move substrates, the substrate clamp exchanger comprising:
a substrate clamp carrier configured to carry at least one replacement substrate clamp; and
a picker configured to automatically pick from the substrate clamp carrier a replacement substrate clamp for attaching to the support stage.

According to an embodiment, there is provided a method for exchanging substrate clamps of a support stage configured to move substrates, the method comprising:
carrying at least one replacement substrate clamp with a substrate clamp carrier; and
automatically picking from the substrate clamp carrier a replacement substrate clamp for attaching to the support stage.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary substrate bonding method, according to an embodiment.
Figure 2 is a schematic diagram illustrating a method of placement of dies by a moveable stage with recesses, according to an embodiment.
Figure 3 schematically depicts a die clamp exchanger.
Figure 4 schematically depicts a die clamp carrier.
Figure 5 schematically depicts an alternative die clamp exchanger.
Figure 6 schematically depicts part of a die clamp exchanger such as the die clamp exchanger shown in Figure 3.
Figure 7 schematically depicts the part shown in Figure 6 at a different point in time.
Figure 8 schematically depicts a perspective view of the die clamp exchanger shown in Figure 6 and Figure 7.
Figure 9 schematically depicts a plan view of part of the die clamp exchanger shown in Figure 8.
Figure 10 schematically depicts an engagement member of a transfer arm of the die clamp exchanger shown in Figure 3, for example.
Figure 11 schematically depicts an alternative arrangement of part of a die clamp exchanger.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

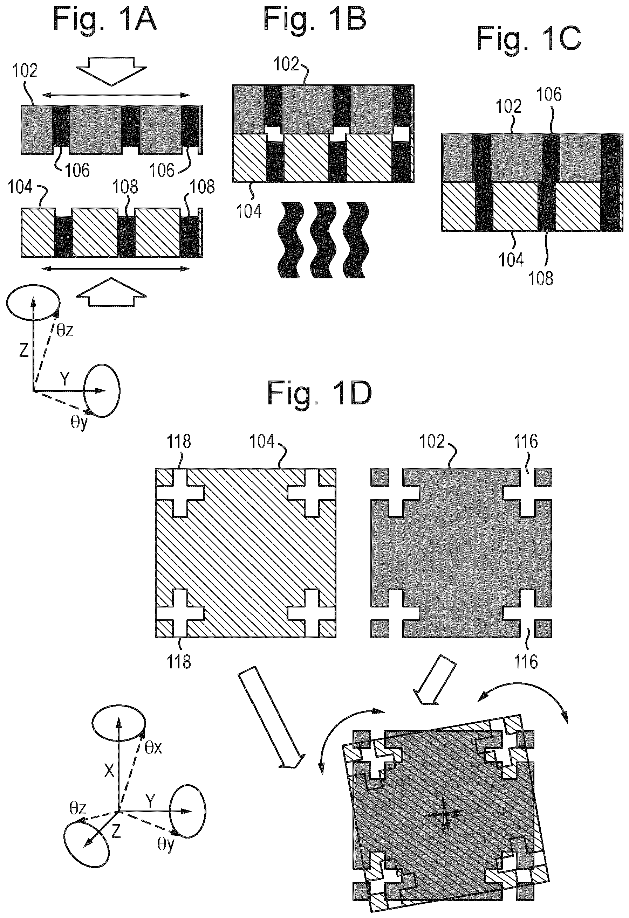

Reference is now made to Figures 1A-1D, which are schematic diagrams illustrating an exemplary substrate bonding method, more specifically an exemplary die bonding method, consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1 A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1A, the donor die 102 and the target die 104 may be brought together along the z-axis, while the position of the donor die 102 or the target die 104 may be adjusted in the x-y plane (e.g., perpendicular to the z-axis of approach). As shown in Figure 1B, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 and/or in the electrically active areas 108 of the target die 104 which may cause physical contact or electrical contact between the electrically active areas 106 and the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or subtractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non- zero linewidth portion of the wafer volume when separating dies. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

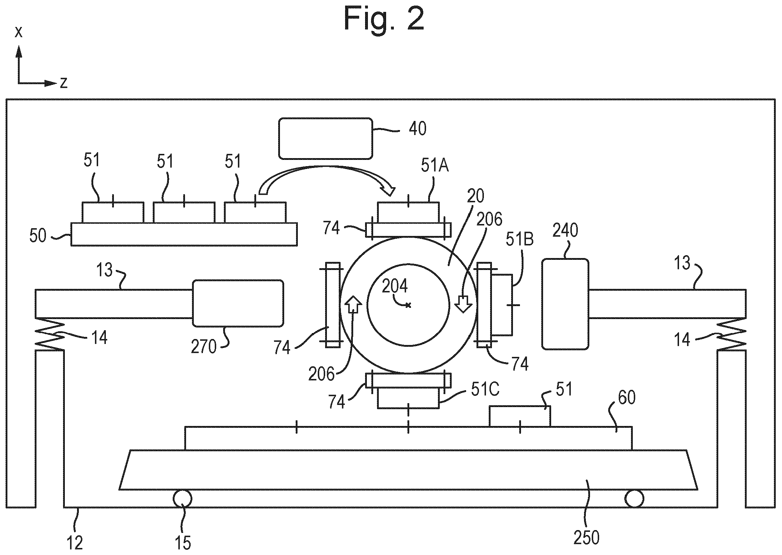

Figure 2 is a schematic diagram illustrating a method of placement of donor dies by a moveable stage with recesses. Figure 2 is described with reference to "donor die" and "target die", which are relative descriptors and donor die may instead be target die and vice versa. Figure 2 is a cross-sectional view of placement of donor die 51A-51C using support stage 20. The support stage 20 is substantially circular in the x-z plane, with a longitudinal axis 204 along the y-direction (e.g., the support stage 20 is substantially cylindrical in three dimensions). The support stage 20 may instead have a different cross-sectional shape, such as square, hexagonal, etc. The support stage 20 may have a symmetrical (e.g., as shown) cross-section with one or more axis of symmetry, or asymmetrical cross-sectional area (for example, an irregular polygon).

The support stage 20 has die clamps 74. The placement of the die clamps 74 may be symmetrical or asymmetrical around the cross-sectional area of the support stage 20. The support stage 20 may have a substantially symmetrical cross section but have asymmetric placement of recesses. For example, the support stage 20 may have a cross-section that is a regular hexagon but have recesses placed asymmetrically along longitudinal faces. The die clamps 74 are capable of accepting donor dies, such as the donor dies 51.

The support stage 20 may be controllably moved in a direction 206 about the longitudinal axis 204. The direction 206 is provided as an example. The support stage 20 may instead be rotated in an opposite direction or any appropriate direction, translated along the x, y, or z direction or any combination thereof. The support stage 20 may be operated in both rotational and translational modes, including sequentially or at the same time. For example, the support stage 20 may move in the negative x-direction towards a support structure 250 while also rotating about the longitudinal axis 204. The support stage 20 may move continuously or intermittently. For example, the support stage 20 may rotate in the direction 206 and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the support stage 20 is substantially zero), but the positions may instead correspond to continuous (or quasi-continuous movement) or operations may occur while the support stage 20 is moving in one or more directions (e.g., rotationally, translationally, etc.).

A first position, such as corresponding to the position depicted for the donor die 51A, may correspond to placement of die in die clamps 74 of the support stage 20. The donor die 51A may be placed on the die clamp 74 by a picker 40. The picker 40 may place the donor die 51A on the support stage 20 on the die clamp 74 based on alignment information, based on positional information of the support stage 20, etc. The picker 40 may place the donor die 51A on the support structure at a given position relative to the die clamp 74. For example, the picker 40 may center the donor die 51A relative to the die clamp 74. The picker 40 may have intrinsic error or inaccuracy.

The second position, such as corresponding to the position depicted for the donor die 51B, may correspond to measurement of the position of the die in recesses (e.g., of the donor die 51B relative to the die clamp 74) of the support stage 20. The position (e.g., location) of the donor die 51B may be measured by a location measurement element 240. The location measurement element 240 may measure an actual position of the donor die 51B, in relative (such as relative to the die clamp 74) or absolute terms (such as in distances from an origin point on the support stage 20, on the location measurement element 240, etc.). The location measurement element 240 may be a camera, e.g., a two-dimensional camera, two or more one-dimensional cameras, an optical camera, etc., or another measurement device. The location measurement element 240 may be made up of multiple location measurement elements, such as an in-plane measurement device which may measure locations in the x-y plane (relative to the refence axes) and an out of plane measurement device which may measure locations or distances in the z direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the support stage 20.

Once the position of the donor die 51B is measured, the support stage 20 may move (e.g., in the direction 206), so that the donor die 51B occupies the position of the donor die 51C which may be a third position of the support stage 20. The third position of the support structure will now be described with reference to the donor die 51C.

The third position, such as corresponding to the position depicted for the donor die 51C, may correspond to placement of the die on a corresponding target, for example, an acceptor substrate 60. The acceptor substrate 60 may comprise one or more target dies which may be sequentially contacted by a donor die during various movements of the support stage 20.

The acceptor substrate 60 is supported by the support structure 250. The donor die 51C may be placed on the acceptor substrate 60 by motion of the support stage 20 towards the acceptor substrate 60. Alternatively or additionally, the support structure 250 may also be a moveable structure operable to bring the donor die 51C and the acceptor substrate 60 into contact.

Once the donor die 51C is placed on the acceptor substrate 60, the support stage 20 and the support structure 250 may operate (individually or in concert) to place additional donor dies on the acceptor substrate 60. For example, the support structure 250 may move in the negative z-direction so that another part of the acceptor substrate 60 is proximate to the support stage 20 and a donor die (for example, the donor die 51B after rotation of the support stage 20) may be placed on the acceptor substrate 60. The relative motion of the support stage 20 and the support structure 250 may occur in any appropriate direction. A direction of gravity is not depicted, but the placement of the donor die 51C on the acceptor substrate 60 may experience gravitation effects. For example, the placement of the donor die 51C on the acceptor substrate 60 may be encouraged by gravity (e.g., occur in the direction of gravity) or be retarded by gravity (e.g., occur opposite the direction of gravity). Gravitational effects may be balanced by die clamps, suction, vacuum, and other forces.

The stage 20 shown in Figure 2 is for die placement. The stage 20 is for placing dies 51, for example onto an acceptor substrate 60. The stage 20 comprises an actuator. The actuator is configured to cause the stage 20 to accept the dies 51 from the picker 40 and subsequently transport the dies 51 to alignment sensor 240 and finally place the dies 51 on the acceptor substrate 60.

In an embodiment the stage 20 comprises an actuator. The actuator may be a Lorentz force actuator. Alternatively a different type of actuator may be used. The actuator is configured to apply forces to cause the stage 20 to move at least one die 51, for example for placement of the die 51.

In an embodiment the stage 20 comprises a movable member configured to hold at least one die 51. For example, as shown in Figure 2 in an embodiment the movable member is configured to hold four dies 51. The movable member may comprise at least one die clamp 74. As shown in Figure 2, in an embodiment the movable member comprises a plurality of die clamps 74, for example at least four die clamps 74. Each die clamp 74 may be configured to hold a die 51. The die clamps 74 may be provided at an outward facing surface of the movable member of the stage.

In an embodiment, the actuator is configured, on actuation, to move the movable member of the stage 20. In an embodiment the actuator is configured, on actuation, to move the movable member in six degrees of freedom. The six degrees of freedom may be movement in the X direction (i.e. the vertical direction shown in Figure 2), movement in the Z direction (i.e. the horizontal direction shown in Figure 2), movement in the Y direction (i.e. into and out of the plane of Figure 2), rotation about the Y axis, tilt about the X axis and tilt about the Z axis.

The actuator is configured to move the movable member at high accuracy. High accuracy is required for placing the dies 51 onto the acceptor substrate 60.

As shown in Figure 2, in an embodiment the acceptor substrate 60 is supported by a support structure 250. In an embodiment the support structure 250 is configured to move the acceptor substrate 60 at high accuracy. In an embodiment, a controller is configured to control the stage 20 and the support structure 250 so as to accurately place the die 51 from the donor substrate 50 to the acceptor substrate 60.

The actuator is configured, on actuation, to move the movable member of the stage 20 with substantially zero friction. An embodiment of the invention is expected to achieve high accuracy of die placement.

Figure 2 schematically depicts a bonding tool for bonding a die 51 to an acceptor substrate 60. The bonding tool comprises the stage 20 for die placement.

As shown in Figure 2, in an embodiment the bonding tool comprises a base frame 12. As shown in Figure 2, in an embodiment the support structure 250 that supports the acceptor substrate 60 is coupled to the base frame 12 by at least one bearing 15. In an embodiment the support structure 250 comprises a plurality of stages that may be stacked relative to each other via a plurality of bearings. For example, the support structure 250 may comprise a long stroke module for relatively coarse positioning of the acceptor substrate 60 over a longer distance, and a short stroke module for higher accuracy positioning of the acceptor substrate 60 over a shorter stroke. The short stroke module may be stacked on the long stroke module.

As shown in Figure 2, in an embodiment the bonding tool comprises a metrology frame 13. The metrology frame 13 may be referred to as an isolated frame. The metrology frame 13 may be isolated relative to the base frame 12.

For example, as shown in Figure 2, in an embodiment the bonding tool comprises an isolator 14. The isolator 14 is configured to substantially isolate the metrology frame 13 from the base frame 12. By isolating the metrology frame 13 from the base frame 12, vibrations of the base frame 12 may have less effect on the metrology frame 13.

For example, in an embodiment measurements of the location of a die 51 may be made relative to the metrology frame 13. An embodiment of the invention is expected to achieve high accuracy of positioning of a die 51.

In an embodiment part of the stage 20 is secured to the base frame 12. For example, a support of the stage 20 may be fixed to the base frame 12. In an embodiment, the position of the movable member of the stage 20 is measured and controlled with respect to the metrology frame 13.

An embodiment of the invention is expected to have relatively low sensitivity of the stage 20 for external vibrations. This can help to achieve high position accuracy of the stage 20, and therefore the at least one die 51 to be placed.

An embodiment of the invention is expected to achieve high internal eigenfrequencies of the stage 20. Such high internal eigenfrequencies are expected to allow a high control bandwidth to be realised. This is expected to result in high position accuracy of the stage 20.

Embodiments of the invention are primarily described with reference to embodiments in which the stage 20 is generally wheel shaped. Unless specific reference is made to the geometry of the stage 20, it is to be understood that such a wheel shape is not required.

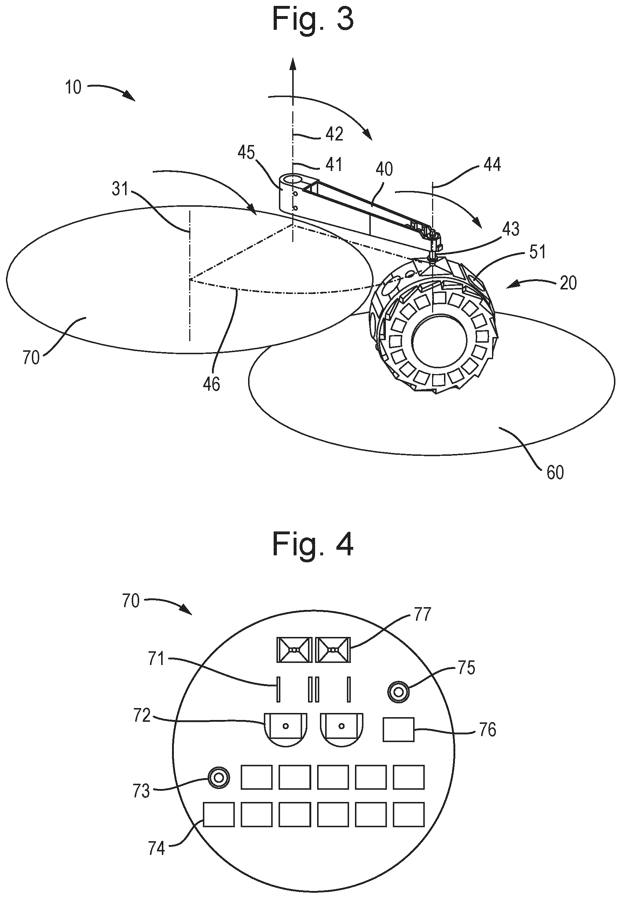

As shown in Figure 2, in an embodiment the bonding tool comprises at least one location measurement element 240, which may be referred to as an alignment sensor. As shown in Figure 2, the location measurement element 240 may be secured to the metrology frame 13. As shown in Figure 3, in an embodiment the bonding tool comprises a substrate clamp exchanger, which is referred to as a die clamp exchanger 10 in the embodiment. Part of the die clamp exchanger 10 may be secured to the metrology frame 13 or to the base frame 12. The die clamp exchanger 10 is configured to exchange a die clamp 74 of the stage 20 for a replacement die clamp. Alternatively, the die clamp exchanger 10 may be omitted. For example, the picker 40 may be configured to exchange die clamps 74.

As shown in Figure 2, in an embodiment the bonding tool comprises the picker 40. The picker 40 may be referred to as a pick and place robot. The picker 40 may comprise a transfer arm. Alternatively, the picker 40 may comprise a different type of in-plane mover such as a rotator.

Figure 3 schematically depicts a die clamp exchanger 10. The die clamp exchanger 10 may be for a bonding tool, for example of the type shown in Figure 2. In an embodiment the die clamp exchanger 10 is configured to exchange die clamps 74 (see Figure 4) of a support stage 20. The stage 20 is configured to facilitate moving dies 51 from the donor substrate 50 to the acceptor substrate 60, for example. In another embodiment, the substrate clamp exchanger may be configured to exchange a wafer clamp of a support stage for a replacement wafer clamp, wherein the wafer may be a donor wafer or an acceptor wafer.

As shown in Figure 3, in an embodiment the stage 20 is configured to rotate. By rotating the stage 20, a die 51 that is placed on the top of the stage 20 is flipped during the process of moving the die 51 onto the acceptor substrate 60. It is not essential for a rotating stage to be provided in order to flip the dies 51. For example, in an alternative embodiment the stage may be formed as a flipper or a vertical picker. The die clamp exchanger 10 is described primarily in the context of use with a rotating stage 20, although the use of the die clamp exchanger 10 is not limited to use with a rotating stage 20.

As shown in Figure 3, in an embodiment the substrate clamp carrier 70 and the acceptor substrate 60 may be provided at different vertical positions. The substrate clamp carrier 70, also referred to as the die clamp carrier may be located higher than the acceptor substrate 60. As shown in Figure 3, the die clamp carrier 70 may be offset horizontally from the acceptor substrate 60. As shown in Figure 3, the die clamp carrier 70 and the acceptor substrate 60 may overlap partly in plan view. In another embodiment, the substrate clamp carrier may be configured to carry a wafer clamp, or a clamp for clamping another type of substrate.

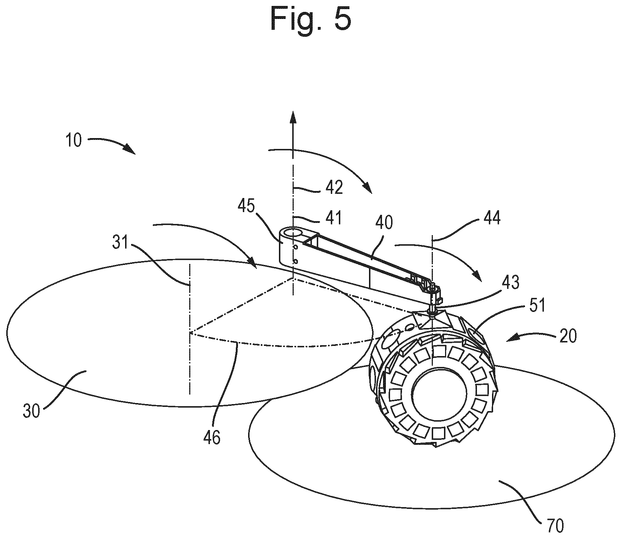

In an embodiment the die clamp exchanger 10 comprises a donor support 30 (e.g. see Figure 5). The donor support 30 is configured to support a die clamp carrier 70. For example, the donor support 30 may be configured to hold the die clamp carrier 70. The die clamp carrier 70 may be supported at an upper surface of the donor support 30.

In an embodiment, the donor support 30 is configured to rotate the die clamp carrier 70. Figure 3 schematically depicts the rotational axis 31 of the donor support 30. In an embodiment the donor support 30 is configured to rotate the die clamp carrier 70 about the rotational axis 31. In an embodiment the die clamp carrier 70 is located on the donor support 30 such that the centre of the die clamp carrier 70 substantially coincides with the rotational axis 31 of the donor support 30. Of course there may be some offset between the centre of the die clamp carrier 70 and the rotational axis 31 of the donor support 30. Figure 3 schematically depicts the rotation by the presence of a curved arrow above the rotational axis 31.

As shown in Figure 3, in an embodiment the picker 40 is configured to rotate about a transfer axis 41. The transfer axis 41 may be a rotational axis. For example, the transfer axis 41 may be a rotational axis for back and forth motion of the picker 40. The picker 40 may rotate back and forth between locations on die clamp carrier 70 and the stage 20. In an embodiment the picker 40 is configured to rotate to different positions for picking up respective die clamp 74 from the die clamp carrier 70. The rotational position at which the picker 40 picks up the die 51 may depend on the location of the die clamp 74 on the die clamp carrier 70 and the rotational position of the die clamp carrier 70. In an embodiment the picker 40 is configured to repeatedly rotate to substantially a similar position for depositing the picked up die clamps 74 onto the stage 20.

In an embodiment the picker 40 comprises a pivot 45 for pivoting around the transfer axis 41. In an embodiment the picker 40 comprises two bushes connected with an underpressure so as to reduce the possibility of particles escaping while allowing rotation of the picker 40 about the pivot 45.

As shown in Figure 3, in an embodiment the picker 40 is actuatable substantially perpendicularly to the die clamp carrier 70. For example, as shown in Figure 3 in an embodiment the picker 40 is configured for vertical motion along a translational axis 42. In an embodiment the translational axis 42 is substantially coaxial with the transfer axis 41 of the rotational motion of the picker 40. Providing that the picker 40 is capable of making vertical motions, the picker 40 may readily be able to pick and place the die clamps 74.

As shown in Figure 3, in an embodiment the picker 40 comprises an engagement member 43. In an embodiment the engagement member 43 is configured to engage with a die clamp 74. For example, the engagement member 43 may be configured to engage with a die clamp 74 so as to transfer the die clamp 74 from the die clamp carrier 70. In an embodiment the engagement member 43 comprises a pipette or a collet. In an embodiment the engagement member 43 is configured to provide an underpressure for vacuum clamping a die clamp 74 to the engagement member 43. Additionally or alternatively, an electrostatic force may be applied to engage the die clamp 74 with the engagement member 43. Additionally or alternatively, a mechanical mechanism may be provided to engage the die clamp 74 with the engagement member 43.

As shown in Figure 3, in an embodiment the engagement member 43 is rotatable. For example, the engagement member 43 may be rotatable about a rotational axis 44. In an embodiment the engagement member 43 is rotatable such that a die clamp 74 engaged by the engagement member 43 is rotatable. As shown in Figure 3, in an embodiment the rotational axis 44 of the engagement member 43 is substantially parallel to the rotational axis 31 of the donor support 30 and/or the translational axis 42 of the picker 40 and/or the transfer axis 41 for rotational movement of the picker 40. In an embodiment the controller is configured to control rotation of the engagement member 43 so as to be able to always place the die clamps 74 on the stage 20 under substantially the same angle.

Figure 4 is a schematic plan view of the substrate clamp carrier 70. As shown in Figure 4, in an embodiment the substrate clamp carrier 70 is a die clamp carrier substrate and is substantially circular. Alternative shapes or designs of substrate clamp carrier may be used.

As shown in Figure 4, in an embodiment the die clamp carrier 70 is configured to carry at least one replacement die clamp 74. Such a replacement die clamp 74 is for replacing a die clamp 74 on the stage 20, or a die clamp that has already been removed from the stage 20. The replacement die clamp 74 may be substantially identical to the die clamp 74 to be replaced. Alternatively, the replacement die clamp 74 may be different from the die clamp 74 to be replaced. For example, one or more die clamps 74 of the stage 20 may be replaced with die clamps 74 configured to clamp dies 51 of different sizes. The die clamps 74 of the stage 20 may be replaced by replacement die clamps 74 that are sized differently. Additionally or alternatively, die clamps 74 may be replaced by replacement die clamps 74 that have a different groove pattern.

As shown in Figure 3, in an embodiment the picker 40 is configured to automatically pick from the die clamp 70 a replacement die clamp 74 for attaching to the support stage 20. In an embodiment the die clamp exchanger 10 is configured to automatically exchange die clamps 74 of the stage 20. By automatically exchanging die clamps 74, it may not be necessary to exchange die clamps manually.

As illustrated in Figure 2, in an embodiment the stage 20 is located close to other components of the bonding tool. The stage 20 may be surrounded by different types of machinery. By allowing for automatic picking of the die clamps 74 from the die clamp carrier 70, die clamp exchange may be facilitated.

An embodiment of the invention is expected to allow for quicker exchange of die clamps 74. An embodiment of the invention is expected to reduce any throughput loss as a result of exchanging die clamps 74.

An embodiment of the invention is expected to reduce particle contamination. By avoiding the need for human interaction, particle contamination may be reduced.

By facilitating replacement of die clamps 74, the accuracy of the bonding by the bonding tool may be maintained. For example, during use of the bonding tool the die clamps 74 may degrade in quality. Additionally or alternatively, the die clamps 74 can collect debris during use. By exchanging the die clamps 74 automatically, cleaning of the die clamps 74 may be facilitated. By cleaning the die clamps 74, the accuracy of the bonding processes may be improved.

Although not shown in Figure 2, in an embodiment a handler is provided to transport the die clamp carrier 70 from outside to inside the bonding tool. In an embodiment the handler is configured to transport the die clamp carrier 70 to outside the bonding tool after a process of exchanging die clamps 74 has been completed.

In an embodiment the handler is further configured to transport donor substrates 50 from outside the bonding tool to inside the bonding tool. Such donor substrates 50 may be supported by the donor support 30. In an embodiment the handler is configured to transport the donor substrate 50 back outside the bonding tool once the applicable dies 51 have been taken off it.

In an embodiment the die clamp exchanger 10 takes advantage of some of the same components as already provided for the bonding tool. For example, the same handler that handles the donor substrates 50 may be used to handle the die clamp carrier 70. An embodiment of the invention is expected to reduce the amount of machinery required for the bonding tool. In an alternative embodiment, a dedicated handler may be provided for the die clamp carrier 70, wherein the dedicated handler is separate from any handler that handles donor substrates 50.

As shown in Figure 3, in an embodiment the picker 40 comprises a transfer arm configured to pick the replacement die clamp 74 and transfer the replacement die clamp 74 to the support stage 20. However, it is not essential for the picker 40 to comprise a transfer arm. In an alternative embodiment, the picker 40 comprises a different type of in-plane pick and place element. For example, the picker 40 may comprise a rotating turret.

In an embodiment, during a bonding process a donor substrate 50 comprising dies 51 is provided in the location where the die clamp carrier 70 is shown in Figure 3. In an embodiment the picker 40 is configured to pick and place dies 51 from such a donor substrate 50 to the support stage 20.

In an embodiment the same transfer arm (or other in-plane pick and place element) is configurable to pick and place dies 51 and to pick and place replacement die clamps 74, depending on whether a bonding process or a die clamp exchange process is being performed. The die clamp exchanger 10 may be configured to make use of equipment such as the donor support 30 and the picker 40 that are already provided for bonding processes. An embodiment of the invention is expected to reduce (or at least not unnecessarily increase) the complexity of the equipment for bonding.

In an embodiment the die clamp exchanger 10 comprises a controller. The controller is configured to control the die clamp exchanger 10. In an embodiment the controller is configured to control the die clamp exchanger 10 to automatically exchange die clamps 74 of the support stage 20.

In an embodiment the die clamp exchanger 10 is configured to exchange all of the die clamps 74 of the support stage 20. As shown in Figure 4, in an embodiment the die clamp carrier 70 comprises parking spots for the die clamps 74 that are to be replaced.

In an embodiment a method for exchanging substrate clamps comprises loading the substrate clamp carrier 70 onto a table such as the donor support 30. In an embodiment the substrate clamp carrier 70 is loaded using the same handler as used for loading/unloading the donor substrate 50. The substrate clamp carrier 70 may be a die clamp carrier carrying at least one replacement die clamp 74.

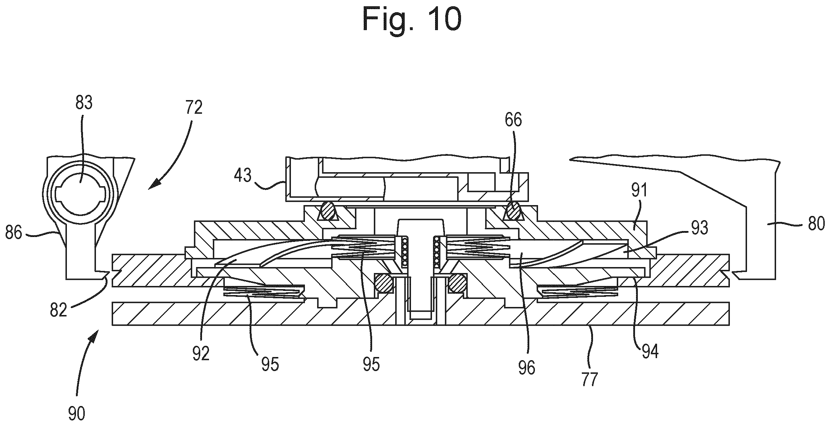

In an embodiment, the picker 40 comprises at least one picker clamp 77, as shown in Figure 10. The picker clamp 77 is configured to clamp dies 51, for example so as to transfer dies 51 from a donor substrate 50 to the stage 20.

In an embodiment the method for exchanging die clamps 74 comprises detaching from the picker 40 a picker clamp 77. The current picker clamp 77 needs to be removed. In an embodiment the picker 40 comprises a plurality of transfer arms. Each transfer arm may comprise a corresponding picker clamp 77. In an embodiment a plurality of picker clamps 77 are removed from the picker 40.

In an embodiment the method comprises parking the detached picker clamp 77 on the die clamp carrier 70. As shown in Figure 4, in an embodiment the die clamp carrier 70 comprises at least one parking space 71 for the current picker clamp 77 of the picker 40. In Figure 4, the die clamp carrier 70 is shown having two parking spaces for picker clamps 77 of the picker 40. In an alternative embodiment, the die clamp carrier 70 comprises a single picker clamp parking space 71 or more than two picker clamp parking spaces 71.

In an alternative embodiment, the detachment and parking of the picker clamp 77 may be omitted. For example, the picker clamp 77 may have already been detached and parked. Alternatively, the picker clamp 77 may be configured to clamp replacement die clamps 74 (in addition to being configurable to clamp dies 51).

By detaching the picker clamp 77 from the picker 40, a dedicated attachment for picking and transferring replacement die clamps 74 may be used. This may help to improve the speed and/or accuracy of a die clamp exchanging process. An embodiment of the invention is expected to improve reliability of exchanging die clamps 74.

In an embodiment the method comprises carrying with the die clamp carrier 70 at least one gripper 72. The gripper 72 is for gripping a replacement die clamp 74 of the stage 20. For example, Figure 4 shows a die clamp carrier 70 configured to carry two grippers 72. The grippers 72 are to be used by the picker 40 to handle die clamps 74 of the stage 20. For example, when the picker 40 comprises two transfer arms, then the two grippers 72 shown in Figure 4 may be provided for the respective transfer arms of the picker 40. In an alternative embodiment, the die clamp carrier 70 is configured to carry a single gripper 72 or more than two grippers 72 (e.g. when the picker 40 comprises a rotator that has a plurality of clamps).

In an embodiment the method comprises attaching the gripper 72 to the picker 40. For example, the gripper 72 may be mechanically attachable to the picker 40. Alternatively, the gripper 72 may be pneumatically clamped to the engagement member 43 of the picker 40.

By providing the gripper 72, the gripper 72 may be designed for accurate transfer of the die clamps 74. For example, the gripper 72 may be shaped so as to mechanically transfer the die clamps 74. In an embodiment the gripper 72 comprises engagement members (e.g. arms) configured to grip the die clamp 74 so as to transfer the die clamp 74 in a controlled orientation. An embodiment of the invention is expected to improve accuracy of exchanging die clamps 74.

In an embodiment the interface between the picker 40 and the gripper 72 is substantially identical to the interface between the picker 40 and the picker clamp 77. For example, the same engagement member 43 may be configured to interface with the gripper 72 or with the picker clamp 77 depending on whether a bonding process or a die clamp exchange process is being performed. In an embodiment the controller is configured to selectively control engagement of the gripper 72 and the picker clamp 77 with the engagement member 43.

In an embodiment the method comprises detaching from the support stage 20 a die clamp 74 to be replaced. In an embodiment the die clamp 74 is detached before the replacement die clamp 74 is picked from the die clamp carrier 70. Alternatively, it may not be necessary to detach the die clamp 74 to be replaced, for example if the die clamp 74 has already been detached. In an embodiment the method comprises parking the detached die clamp 74 on the die clamp carrier 70.

In an embodiment at least one engagement member 43 of the picker 40 is configured to move towards the stage 20. A first die clamp 74 can be picked from the stage 20. The picker 40 is configured to move the picked die clamp 74 towards the die clamp carrier 70. In an embodiment the die clamp 74 is parked on an empty parking space on the die clamp carrier 70.

For example, as shown in Figure 4 in an embodiment the die clamp carrier 70 comprises at least one die clamp parking space 73. A die clamp 74 to be replaced can be parked in the die clamp parking space 73. As shown in Figure 4, in an embodiment the die clamp carrier 70 comprises a single die clamp parking space 73. In an alternative embodiment, the die clamp carrier 70 may comprise a plurality of die clamp parking spaces 73. By reducing the number of die clamp parking spaces 73, a greater area of the die clamp carrier 70 may be used for carrying replacement die clamps 74, for example.

In an embodiment the interface between the die clamp 74 and the die clamp carrier 70 is substantially identical to the interface between the die clamp 74 and the stage 20. For example, the die clamp carrier 70 may comprise an engagement portion at each die clamp parking space 73 configured to engage with a die clamp 74. The engagement portion may be configured to mechanically hold a die clamp 74.

In an embodiment the method comprises automatically picking from the die clamp carrier 70 a replacement die clamp 74. The replacement die clamp 74 is for attaching to the support stage 20. In an embodiment the picker 40 is configured to pick the replacement die clamp 74 from the die clamp carrier 70. When a gripper 72 is used, the picker 40 is configured to pick the replacement die clamp 74 using the gripper 72. The gripper 72 grips the replacement die clamp 74 so that the picker 40 can transfer the replacement die clamp 74 to the stage 20.

In an embodiment the method comprises attaching the replacement die clamp 74 to the stage 20. In an embodiment the replacement die clamp 74 is placed on the first empty space on the stage 20. In an embodiment the replacement die clamp 74 is mechanically attached to the stage 20.

In an embodiment the method comprises repeating the steps of detaching a die clamp 74 from the stage 20 and automatically picking a replacement die clamp 74 from the die clamp carrier 70. For example, the method may comprise repeatedly detaching from the support stage 20 a die clamp 74 to be replaced, parking the detached die clamp 74 on the die clamp carrier 70, and automatically picking from the die clamp carrier 70 a replacement die clamp 74 for attaching to the support stage 20. In an embodiment these steps are repeated until all current die clamps 74 have been removed from the stage 20 and placed on the die clamp carrier 70, and all new die clamps 74 are mounted on the stage 20.

As shown in Figure 4, in an embodiment the die clamp carrier 70 comprises a single die clamp parking space 73. When the first die clamp 74 to be replaced is parked in the die clamp parking space 73, then there is no space for further die clamps 74. Once the first replacement die clamp 74 is picked from the die clamp carrier 70, it leaves behind a die clamp parking space 73 that may then be used by the next die clamp 74 that is removed from the stage 20. By using spaces on the die clamp carrier 70 for both die clamps 74 that are removed from the stage 20 and for replacement die clamps 74 to be attached to the stage 20, the overall area of the die clamp carrier 70 may be used more efficiently.

In an embodiment the stage 20 comprises a calibration substrate 76. The calibration substrate 76 may be located at one of the plurality of positions on the stage 20 where a die clamp 74 may be provided. One of the die clamp spaces may be taken up by the calibration substrate 76. In an embodiment the calibration substrate 76 comprises a pattern to be recognised by a sensor. In an embodiment the calibration substrate 76 is configured for facilitating calibration of a sensor of the bonding tool. For example, the bonding tool may comprise one or more sensors for sensing a position of a die 51 or a die clamp 74 on the stage 20. In an embodiment the sensor is configured to measure the calibration substrate 76 so as to calibrate the sensor.

In an embodiment the method comprises detaching from the support stage 20 a calibration substrate 76 to be replaced. In an embodiment the calibration substrate 76 comprises a structure (e.g. a periodic structure) for calibrating a measurement sensor. In an embodiment the method comprises parking the detached calibration substrate 76 on the die clamp carrier 70. For example, as shown in Figure 4, in an embodiment the die clamp carrier 70 comprises a calibration substrate parking space 75. In an embodiment the interface between the die clamp carrier 70 and the calibration substrate 76 is substantially identical to the interface between the stage 20 and the calibration substrate 76. In an embodiment the interface between the die clamp carrier 70 and the calibration substrate 76 is substantially identical to the interface between the die clamp carrier 70 and the die clamp 74.

It is not essential for the calibration substrate 76 to be detached from the stage 20. In an alternative embodiment, the calibration substrate 76 may have already been detached from the stage 20. Alternatively, the stage 20 may not have previously used a calibration substrate 76. In an alternative embodiment, the stage 20 may be configured such that the calibration substrate 76 is permanently attached to the stage 20. It may not be necessary to replace the calibration substrate 76 of the stage 20.

In an embodiment the picker 40 is configured to use a gripper 72 so as to pick and transfer the calibration substrate 76. In an embodiment the gripper 72 for the calibration substrate 76 is the same as the gripper 72 for the die clamp 74. In an alternative embodiment, different grippers 72 are provided for transferring the calibration substrate 76 and the die clamps 74.

In an embodiment the method comprises picking from the die clamp carrier 70 a replacement calibration substrate 76. The replacement calibration substrate 76 is for attaching to the support stage 20. In an embodiment the method comprises placing the replacement calibration substrate 76 on the stage 20. The new calibration substrate 76 may be attached to the stage 20.

As shown in Figure 4, in an embodiment the die clamp carrier is configured to carry at least one calibration substrate 76. The picker 40 is configured to pick from the die clamp carrier 70 the calibration substrate 76. In the arrangement shown in Figure 4, the die clamp carrier 70 comprises a single calibration substrate 76 and a single further calibration parking space 75. In an alternative arrangement, the die clamp carrier 70 may comprise a plurality of replacement calibration substrates 76. For example, the stage 20 may comprise a plurality of calibration substrates 76. The die clamp exchanger 10 may be configured to exchange all of the calibration substrates 76 of the stage 20.

It is not essential for the die clamp carrier 70 to comprise any calibration substrate parking space 75 or calibration substrate 76. In an alternative embodiment, the calibration substrate 76 and the calibration substrate parking space 75 may be omitted from the die clamp carrier 70.

In an embodiment the method comprises detaching the gripper 72 from the picker 40. The detached gripper 72 may be parked on the die clamp carrier 70. In other words, the grippers 72 may be parked on the die clamp carrier 70 again.

In an embodiment the method comprises picking from the die clamp carrier 70 a replacement picker clamp 77 for attaching to the picker 40. As shown in Figure 4, in an embodiment the die clamp carrier 70 is configured to carry at least one replacement picker clamp 77. The replacement picker clamp 77 is configured to clamp dies 51. In an embodiment the picker 40 is configured to pick from the die clamp carrier 70 a picker clamp 77 for attaching to the picker 40.

For example, it may be desirable to replace the picker clamps 77 of the picker 40. In an embodiment the replacement picker clamp 77 and the picker clamp 77 to be replaced are configured to clamp dies 51 of different sizes. By facilitating exchange of picker clamps 77, picker clamps 77 most appropriate for the given die size of a bonding process may be selected and used. An embodiment of the invention is expected to improve the accuracy of a bonding process.

In an embodiment, one or more of the picker clamps 77 is configured to be able to handle a range of different sizes of die 51. It may not be essential to replace the picker clamps 77 of the picker 40 whenever a different size of die 51 is used in a bonding process. In an embodiment the picker clamp 77 is used for a plurality of different bonding processes for dies of different sizes.

In an embodiment when a picker clamp 77 is removed from the picker 40, the picker clamp 77 is cleaned before later being reattached to the picker 40.

In an embodiment the method comprises transferring the detached die clamps 74, calibration substrates 76 and/or picker clamps 77 out of the bonding tool. These items may be cleaned before being used again.

In an embodiment the die clamp carrier 70 has universal geometry, such that the die clamp carrier 70 is configured to hold a plurality of different types of die clamp 74, calibration substrates 76, and picker clamp 77. In an alternative embodiment, the die clamp carrier 70 is dedicated for a specific type of die clamp 74, calibration substrate 76 and/or picker clamp 77. For example, the die clamp carrier 70 may be specific to a particular size of die 51, or to a particular range of size of die 51.

By transferring the die clamp carrier 70 into and out from the bonding tool, it may not be necessary to provide a significant store of die clamps 74 within the bonding tool. An embodiment of the invention is expected to reduce the overall size of the bonding tool.

In an embodiment the die clamps are exchanged as part of a method for bonding dies 51 to substrates.

In the arrangement shown in Figure 3, the carrier stage that supports the die clamp carrier 70 is the same as the stage that supports a donor substrate 50 during a bonding process, namely the donor support 30. However, this is not essential. In an alternative arrangement, a dedicated carrier stage is provided for supporting the die clamp carrier 70.

Figure 5 schematically depicts an alternative die clamp exchanger 10. In the arrangement shown in Figure 5, the carrier stage that supports the die clamp carrier 70 may be further configured to support the acceptor substrate 60. The die clamp carrier 70 may be supported on a stage (the support structure 250) that is further configured to support the acceptor substrate 60 during a bonding process.

In the arrangement shown in Figure 5, the stage 20 functions as the picker of the die clamp exchanger 10. In an embodiment the die clamps 74 and calibration substrates 76 on the die clamp carrier 70 are positioned upside down compared to their orientation in the arrangement shown in Figure 3.

In an embodiment the controller is configured to control the stage 20 to pick the replacement die clamps 74 from the die clamp carrier 70. In an embodiment the vertical motion of the stage 20 and/or the vertical motion of the support structure 250 are controlled so that the stage 20 picks the replacement die clamps 74 from the die clamp carrier 70. In the arrangement shown in Figure 5, the picker of the die clamp exchanger 10 is the support stage 20.

In the arrangement described with reference to Figure 3 and Figure 4, for example, the gripper 72 is temporarily attached to the picker 40 only during a die clamp exchanging process. The interface between the picker 40 and the gripper 72 may be substantially identical to the interface between the picker 40 and the picker clamp 77.

In an alternative embodiment, the picker 40 comprises a gripper 72 configured to selectively grip the at least one replacement die clamp 74 and a picker clamp 77. For example, in an embodiment the picker 40 permanently comprises the gripper 72. The gripper 72 remains part of the picker 40 during both a die clamp exchanging process and during a bonding process. During a die clamp exchanging process, the gripper 72 of the picker 40 is used to grip die clamps 74 so as to transfer the die clamps 74 to the stage 20. During a bonding process, the gripper 72 of the picker 40 is configured to grip the picker clamp 77, such that the picker clamp 77 can clamp the dies 51 to be bonded.

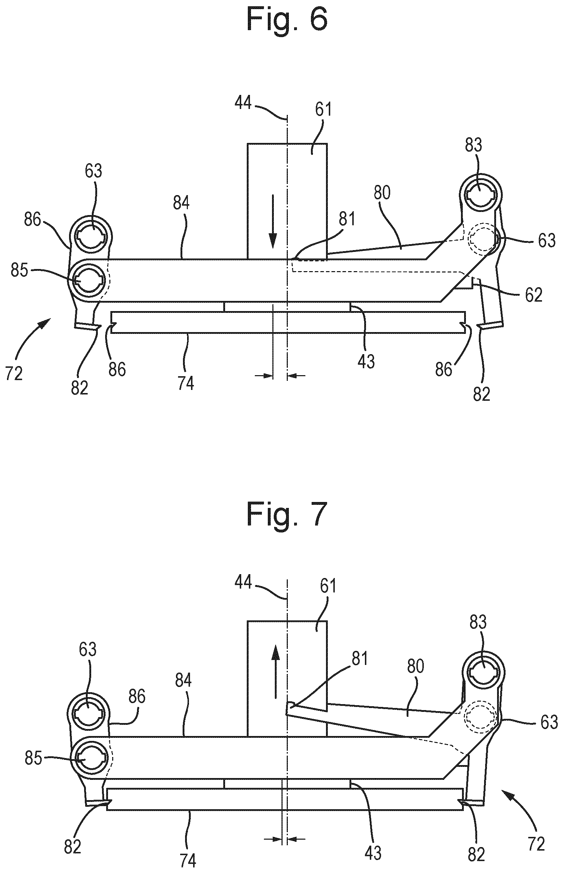

Figure 6 schematically depicts part of the picker 40. In particular, Figure 6 schematically depicts the region around the engagement member 43 of the picker 40. As shown in Figure 6, in an embodiment the picker 40 comprises a gripper 72. Figure 6 schematically shows the gripper 72 gripping a die clamp 74, for example during a die clamp exchanging process.

Figure 7 schematically depicts the same part of the picker 40 shown in Figure 6 but at a different point in time. Figure 6 shows the gripper 72 in an unlocked position, where the gripper 72 is not directly engaged with the die clamp 74. Figure 7 schematically depicts the gripper 72 in a locked position, where the gripper 72 directly engages with the die clamp 74. As shown in Figure 7, in an embodiment the gripper 72 is configured to mechanically engage with (i.e. hold) the die clamp 74.

As shown in Figure 6, in an embodiment the picker 40 comprises a shaft 61. In an embodiment the shaft 61 is configured to rotate so as to control the angular orientation of the die 51 or die clamp 74 held by the picker 40. In an embodiment the shaft 61 comprises a conduit for pneumatic clamping at the engagement portion 43. In an embodiment the engagement portion 43 comprises a vacuum channel to a nozzle of the picker 40.

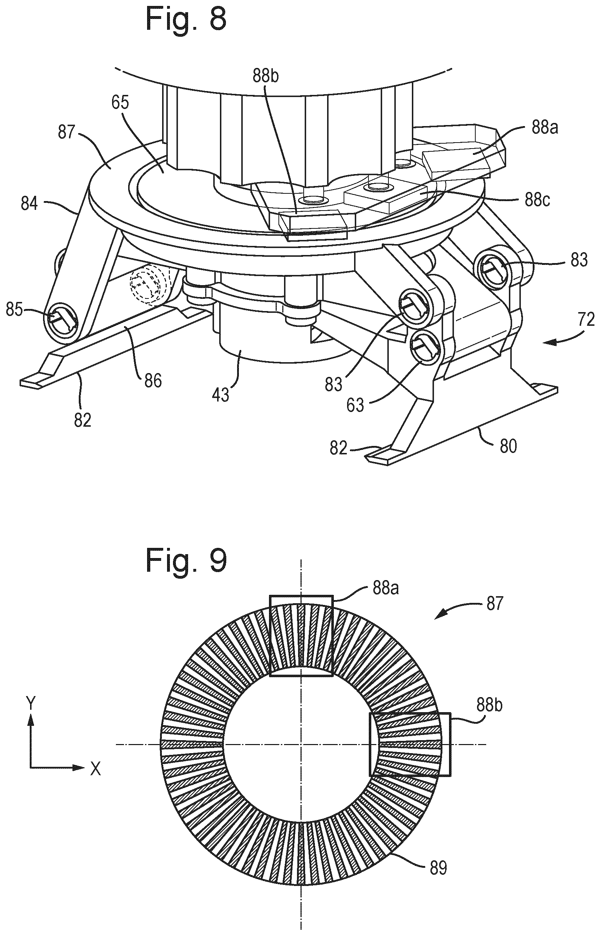

Figure 8 schematically depicts a perspective view of the part of the picker 40 shown in Figure 6 and Figure 7.

As shown in Figure 6, Figure 7 and Figure 8, in an embodiment the picker 40 comprises a gripper connector 62. The gripper connector 62 is configured to connect to the gripper 72. As shown in Figure 8, for example, in an embodiment the gripper connector 62 is configured to protrude radially away from the axis of rotation of the picker 40. In an embodiment the gripper connector 62 is configured to protrude radially beyond a die 51 and/or die clamp 74 to be held by the picker 40.

As shown in Figure 6, for example, in an embodiment the gripper connector 62 is connected to the gripper 72 at one or more hinges 63. In the arrangement shown in Figure 6, the gripper 72 comprises two portions, each hinged to the gripper connector 62 at respective hinges 63. In an embodiment the hinges 63 are elastic. An embodiment of the invention is expected to reduce the creation of particles during use of the picker 40. It is not essential for the hinges 63 to be elastic. In an alternative embodiment the hinges 63 are non-elastic. For example, the hinges 63 may comprise a bearing such as ball bearings or sliding bearings.

As shown in Figure 6 and Figure 7, for example, in an embodiment the gripper 72 comprises an actuation member 81. In an embodiment the actuation member 81 is configured to be actuated by the picker 40 so as to actuate the gripper 72 between the locked position and the unlocked position. In Figure 6, the actuation member 81 is in the unlocked position. In the orientation shown in Figure 6, the unlocked position of the actuation member 81 is a downwards position. In Figure 7, the actuation member 81 is shown in the locked position. In the orientation shown in Figure 7, the locked position is an upwards position of the actuation member 81.

In Figure 6 and Figure 7, the actuation force on the actuation member 81 is shown by a big arrow within the shaft 61 of the picker 40. In an embodiment the picker 40 is configured to pneumatically actuate the gripper 72. A pneumatic actuator may be suitable to provide a relatively large force density. A pneumatic actuator may have a relatively low heat dissipation. An embodiment of the invention is expected to reduce heat dissipation. In an alternative embodiment the picker 40 is configured to actuate the gripper 72 with a different type of actuator such as a voice coil actuator. As a further alternative embodiment, the gripper 72 may be actuated electromagnetically.

As shown in Figure 6 and Figure 7, for example, in an embodiment the gripper 72 comprises a first pivot member 80. In an embodiment the first pivot member 80 of the gripper 72 is hinged to the gripper connector 62 via a hinge 63. When the actuation member 81 is actuated from the unlocked position shown in Figure 6 to the locked position shown in Figure 7, the first pivot member 80 pivots about the hinge 63. When the first pivot member 80 pivots, a finger 82 of the gripper 72 grips the component (e.g. the die clamp 74) that is to be gripped. For example, as shown in Figure 6 the component to be gripped such as the die clamp 74 may comprise one or more grooves configured to accommodate the fingers 82 of the gripper 72. As shown in Figure 6 and Figure 7, for example, in an embodiment the finger 82 of the gripper 72 may be at the opposite end of an L-shape from the actuation member 81 of the gripper 72.

As shown in Figure 6 and Figure 7, for example, in an embodiment the gripper 72 comprises a second pivot member 86. The second pivot member 86 may be provided with a second finger 82 for engaging with an opposite side of the component to be gripped, such as the die clamp 74. When the actuation member 81 of the gripper 72 is actuated to the locked position, then the second finger 82 (shown in the left hand side of Figure 6 and Figure 7) engages with a groove 86 of the die clamp 74 so as to clamp the die clamp 74.

In an embodiment the gripper 72 is configured such that the actuation of the first pivot member 80 causes actuation simultaneously of the second pivot member 86. For example, in an embodiment the gripper 72 comprises a gripper link 84. The gripper link 84 is configured to apply the actuation of the first pivot member 80 to the second pivot member 86. In an embodiment the second pivot member 86 is connected to the gripper connector 62 via a hinge 63. In an embodiment the gripper link 84 is pivotally connected to the first pivot member 80 via a hinge 83. In an embodiment the gripper link 84 is pivotally connected to the second pivot member 86 via a hinge 85.

When the actuation member 81 is actuated to the locked position, the pivoting of the first pivot member 80 causes the hinge 83 with the gripper link 84 to move. This is shown in the comparison from Figure 6 to Figure 7, where the hinge 83 is moved slightly to the right in Figure 7 compared to in Figure 6. As a result of the sideways movement of the gripper link 84, the hinge 85 between the gripper link and the second pivot member 86 also moves to the right. this causes the second pivot member 86 to pivot about the hinge 63 such that the finger 82 grips the die clamp 74 (or other component to be gripped).

As shown in Figure 8, in an embodiment the gripper link 84 comprises a surface 87. In an embodiment the surface 87 is substantially flat. As shown in Figure 8, in an embodiment the surface 87 faces an opposite direction from the engagement member 43. For example, in the orientation shown in Figure 8, the engagement member 43 faces downwards, while the surface 87 faces upwards.

Figure 9 schematically depicts a more detailed view of the surface 87 of the gripper link 84. As shown in Figure 9, in an embodiment the surface 87 comprises a pattern 89. For example, the pattern 89 may comprise a grating. The grating may be a rotary grating. The pattern 89 may comprise a plurality of radially extending lines. The pattern 89 may be for measuring movement of the gripper link 84. Movement of the gripper link 84 may be indicative of the state of the gripper, i.e. whether the gripper 72 is in the locked position, the unlocked position or somewhere in between.

As shown in Figure 8, in an embodiment the gripper 72 is provided with a plurality of measurement sensors 88a, 88b. In an embodiment the measurement sensors 88a, 88b comprise encoder heads. Alternative types of measurement sensor may be used.

Figure 9 schematically depicts the locations of the measurement sensors 88a, 88b relative to the pattern 89 on the surface 87 of the gripper link 84. As shown in Figure 9, in an embodiment the measurement sensors 88a, 88b are located above the pattern 89. The measurement sensors 88a, 88b are located so as to have at least part of the pattern 89 within the field of view.

By providing a plurality of measurement sensors 88a, 88b configured to measure the pattern 89, the position of the fingers 82 of the gripper 72 can be determined at substantially every orientation. As shown in Figure 9, in an embodiment the measurement sensors 88a, 88b are located with a 90° angle between them (in the X-Y plane shown in Figure 9). An exemplary measurement of the position of the gripper 72 is described as follows.

When the gripper 72 is actuated, then the gripper link 84 moves. For example, if the gripper link 84 moves in the X-direction (in the coordinate system shown in Figure 9), then the measurement sensor 88a would measure the displacement by measuring the changes in the pattern 89. Meanwhile, the measurement sensor 88b may not measure the displacement because the displacement of the gripper link 84 may be substantially in line with the lines of the pattern 89. In contrast, when the gripper link 84 (and hence the pattern 89) moves in the Y-direction (in the coordinate system shown in Figure 9), then the measurement sensor 88b would measure the displacement. The measurement sensor 88a may not measure the displacement. When the gripper link 84 moves in any other directions, then both the measurement sensors 88a, 88b may measure some displacement such that the overall displacement may be determined. Accordingly, the location of the fingers 82 of the gripper 72 may be determined.

As shown in Figure 8, in an embodiment a further measurement sensor 88c (which may be an encoder) is provided to measure the rotary position of the shaft 61. As shown in Figure 8, in an embodiment a further surface 65 (e.g. on a disc) is provided. The further surface 65 may comprise a pattern such as a grating pattern. The further measurement sensor 88c may be located so as to measure the pattern on the further surface 65. By measuring the pattern on the further surface 65, the further measurement sensor 88c may measure the rotational position of the shaft 61, which may correspond to the rotational position of the engagement member 43 (and hence the rotational position of a die 51 or die clamp 74).

However, it is not essential to provide such a further measurement sensor 88c as shown in Figure 8. In an alternative embodiment, the further measurement sensor 88c is omitted. In an embodiment a further measurement sensor is located elsewhere so as to measure the rotational position of the shaft 61. For example, such a further measurement sensor may be located on top of the shaft 61 so as to measure the rotational position of the shaft 61.

In a further alternative embodiment, the measurement sensors 88a, 88b are configured to determine the rotational position of the shaft 61 by measuring the pattern 89 on the surface 87 of the gripper link 84.

Figure 10 schematically depicts the gripper 72 gripping a picker clamp 77. As shown in Figure 10, in an embodiment the picker clamp 77 comprises grooves for accommodating the fingers 82 of the gripper 72, thereby facilitating gripping of the picker clamp 77.

As shown in Figure 10, in an embodiment the picker clamp 77 comprises a mass decoupling mechanism 90. The mass decoupling mechanism 90 is configured to limit (i.e. reduce) the mass that is connected to a die 51 to be transferred during a bonding process. An embodiment of the invention is expected to reduce impact forces during a bonding process.

As shown in Figure 10, in an embodiment the mass decoupling mechanism 90 comprises a biasing member 92 such as a spring connecting an upper portion 91 of the picker clamp 77 to a lower portion that is configured to hold the die 51. As shown in Figure 10, in an embodiment a contact point 94 is provided between the upper portion and the lower portion. The biasing member 92 is configured to bring the portions of the picker clamp 77 into engagement at the contact point 94. As shown in Figure 10, in an embodiment the mass decoupling mechanism 90 comprises bellows 95. The bellows 95 may be edge welded bellows. Particles generated during use of the picker clamp 77 may be trapped within the bellows 95, thereby reducing particle contamination. The picker clamp 77 may define an inner region 96 in which particles may be fully encapsulated. As shown in Figure 10, in an embodiment a clearance 93 is provided between the portions of the picker clamp 77.

As shown in Figure 10, in an embodiment a seal 66 is provided to seal the vacuum channel for the picker clamp 77. For example, the seal may be an O-ring. The clearance 93 is provided in view of the uncertainty of the exact location of the contact point 94.

When the picker clamp 77 touches a die 51 to be transferred, or when a clamped die 51 touches the die clamp 74 of the stage 20, then the contact point 94 may open up. In an embodiment an electrical switch is integrated to detect when the contact point 94 opens up. This facilitates detection of an impact force being provided.

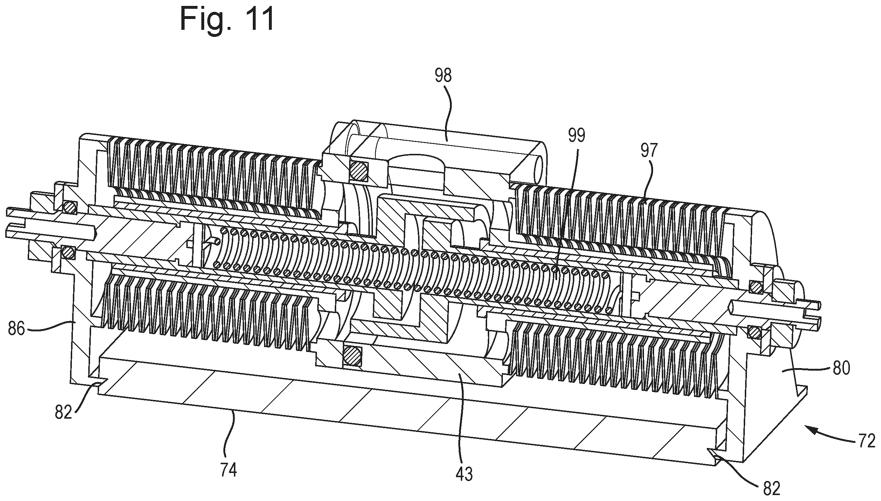

Figure 11 schematically depicts an alternative arrangement of a gripper 72. As shown in Figure 11, in an embodiment the gripper comprises first and second members 80, 86 comprising fingers 82 for gripping a component such as a die clamp 74 or a picker clamp 77. In the gripper 72 shown in Figure 11, linear motion is used to perform the gripping actuation.

The members 80, 86 of the gripper 72 are configured to move sideways so as to move the gripper 72 between the locked position (shown in Figure 11) and the unlocked position (not shown in the figure). For example, the members 80, 86 may move sideways outwardly compared to their position in Figure 11 so as to move to the unlocked position.

As shown in Figure 11, in an embodiment the gripper 72 is provided with an inlet 98. Compressed gas may be provided through the inlet 98 so as to operate the gripper 72, i.e. to actuate the gripper 72 between the locked position and the unlocked position.

In an embodiment the gripper 72 comprises bellows 97 for receiving the compressed gas. The bellows 97 are configured to change in volume as the members 80, 86 of the gripper move sideways.

As shown in Figure 11, in an embodiment the members 80, 86 of the gripper 72 are preloaded with a biasing member 99 such as a spring. The biasing member 99 is configured to maintain the gripper 72 in a closed position, except for when the gripper 72 is actuated to the unlocked position. In an embodiment the bellows 97 are edge welded bellows. The bellows 97 may be configured to encapsulate moving and touching parts of the gripper 72. The bellows 97 may be configured to encapsulate any particles generated during use of the gripper 72.

In an embodiment the gripper 72 comprises a gear connected to racks that are attached to both members 80, 86 of the gripper 72. In an embodiment the gear and the racks are arranged so as to ensure that the sideways movements of the members 80, 86 of the gripper 72 are substantially symmetrical.

Although specific references may be made in this text to the use of die bonding and die clamp exchanger, it should be understood that: the substrate may refer to a donor die, a donor wafer, an acceptor wafer, or another type of substrate, and the substrate clamp may correspondently refer to a donor die clamp, a wafer clamp, or a clamp for another type of substrate. Other aspects of the invention are set out as in the following numbered clauses.
1. A substrate clamp exchanger configured to exchange substrate clamps of a support stage configured to move substrates, the substrate clamp exchanger comprising:
   a substrate clamp carrier configured to carry at least one replacement substrate clamp; and
   a picker configured to automatically pick from the substrate clamp carrier a replacement substrate clamp for attaching to the support stage.
2. The substrate clamp exchanger of clause 1, wherein the support stage comprises at least one substrate clamp to be replaced, wherein the at least one replacement substrate clamp and the at least one substrate clamp to be replaced are configured to clamp substrates of different sizes.
3. The substrate clamp exchanger of clause 1 or 2, wherein the substrate clamp carrier is configured to carry at least one calibration substrate comprising a structure for calibrating a measurement sensor, wherein the picker is configured to pick from the substrate clamp carrier a calibration substrate for attaching to the support stage.
4. The substrate clamp exchanger of any preceding clause, wherein the picker comprises a picker clamp configured to pick the replacement substrate clamp and transfer the replacement substrate clamp to the support stage.
5. The substrate clamp exchanger of clause 4, wherein the picker clamp is further configurable to pick substrates from a donor substrate and transfer the substrates to the support stage.
6. The substrate clamp exchanger of any preceding clause, wherein the substrate clamp carrier is configured to carry at least one replacement picker clamp configured to clamp substrates, wherein the picker is configured to pick from the substrate clamp carrier a replacement picker clamp for attaching to the picker.
7. The substrate clamp exchanger of clause 6, wherein the picker comprises at least one picker clamp to be replaced, wherein the at least one replacement picker clamp and the at least one picker clamp to be replaced are configured to clamp substrates of different sizes.
8. The substrate clamp exchanger of any preceding clause, wherein the substrate clamp carrier is configured to carry at least one gripper attachable to the picker for gripping the at least one replacement substrate clamp.
9. The substrate clamp exchanger of any of clause 1-7, wherein the picker comprises a gripper configured to selectively grip the at least one replacement substrate clamp and a picker clamp configured to clamp the substrates.
10. The substrate clamp exchanger of any of clauses 1-3, wherein the picker is the support stage.
11. The substrate clamp exchanger of any preceding clause, comprising:
   a carrier stage configured to support the substrate clamp carrier.
12. The substrate clamp exchanger of clause 11, wherein the carrier stage is further configurable to support a donor substrate configured to support substrates to be moved by the support stage.
13. The substrate clamp exchanger of clause 11, wherein the carrier stage is further configurable to support an acceptor substrate configured to support substrates that have been received from the support stage.
14. The substrate clamp exchanger of any preceding clause, comprising:
   a controller configured to control the substrate clamp exchanger to exchange substrate clamps of the support stage.
15. A bonding tool configured to bond substrates to substrates, the bonding tool comprising the substrate clamp exchanger of any preceding clause.
16. A method for exchanging substrate clamps of a support stage configured to move substrates, the method comprising:
   carrying at least one replacement substrate clamp with a substrate clamp carrier; and
   automatically picking from the substrate clamp carrier a replacement substrate clamp for attaching to the support stage.
17. The method of clause 16, comprising:
   detaching, from a picker configured to perform the automatic picking, a picker clamp configured to clamp substrates; and
   parking the detached picker clamp on the substrate clamp carrier.
18. The method of clause 17, comprising:
   carrying with a substrate clamp carrier at least one gripper for gripping the at least one replacement substrate clamp; and
   attaching the gripper to the picker.
19. The method of clause 18, comprising:
   detaching the gripper from the picker;
   parking the detached gripper on the substrate clamp carrier; and
   picking from the substrate clamp carrier a replacement picker clamp for attaching to the picker.
20. The method of clause 19, wherein the replacement picker clamp and the detached picker clamp are configured to clamp substrates of different sizes.
21. The method of any of clauses 16-20, comprising, before picking the replacement substrate clamp:
   detaching from the support stage a substrate clamp to be replaced; and
   parking the detached substrate clamp on the substrate clamp carrier.
22. The method of clause 21, comprising repeatedly:
   detaching from the support stage a substrate clamp to be replaced;
   parking the detached substrate clamp on the substrate clamp carrier; and
   automatically picking from the substrate clamp carrier a replacement substrate clamp for attaching to the support stage.
23. The method of any of clauses 16-22, comprising:
   detaching from the support stage a calibration substrate to be replaced, the calibration substrate comprising a structure for calibrating a measurement sensor; and
   parking the detached calibration substrate on the substrate clamp carrier.
24. The method of clause 23, comprising:
   picking from the substrate clamp carrier a replacement calibration substrate for attaching to the support stage.
25. A method for bonding substrates to substrates, the method comprising the method of any of clauses 16-24.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A substrate clamp exchanger configured to exchange substrate clamps of a support stage configured to move substrates, the substrate clamp exchanger comprising:
a substrate clamp carrier configured to carry at least one replacement substrate clamp; and
a picker configured to automatically pick from the substrate clamp carrier a replacement substrate clamp for attaching to the support stage.

2. The substrate clamp exchanger of claim 1, wherein the support stage comprises at least one substrate clamp to be replaced, wherein the at least one replacement substrate clamp and the at least one substrate clamp to be replaced are configured to clamp substrates of different sizes.

3. The substrate clamp exchanger of claim 1 or 2, wherein the substrate clamp carrier is configured to carry at least one calibration substrate comprising a structure for calibrating a measurement sensor, wherein the picker is configured to pick from the substrate clamp carrier a calibration substrate for attaching to the support stage.

4. The substrate clamp exchanger of any preceding claim, wherein the picker comprises a picker clamp configured to pick the replacement substrate clamp and transfer the replacement substrate clamp to the support stage.

5. The substrate clamp exchanger of any preceding claim, wherein the substrate clamp carrier is configured to carry at least one replacement picker clamp configured to clamp substrates, wherein the picker is configured to pick from the substrate clamp carrier a replacement picker clamp for attaching to the picker.

6. The substrate clamp exchanger of any preceding claim, wherein the substrate clamp carrier is configured to carry at least one gripper attachable to the picker for gripping the at least one replacement substrate clamp.

7. The substrate clamp exchanger of any of claim 1-5, wherein the picker comprises a gripper configured to selectively grip the at least one replacement substrate clamp and a picker clamp configured to clamp the substrates.

8. The substrate clamp exchanger of any of claims 1-3, wherein the picker is the support stage.

9. The substrate clamp exchanger of any preceding claim, comprising:
a carrier stage configured to support the substrate clamp carrier.

10. The substrate clamp exchanger of any preceding claim, comprising:
a controller configured to control the substrate clamp exchanger to exchange substrate clamps of the support stage.

11. A bonding tool configured to bond substrates to substrates, the bonding tool comprising the substrate clamp exchanger of any preceding claim.

12. A method for exchanging substrate clamps of a support stage configured to move substrates, the method comprising:
carrying at least one replacement substrate clamp with a substrate clamp carrier; and
automatically picking from the substrate clamp carrier a replacement substrate clamp for attaching to the support stage.

13. The method of claim 12, comprising:
detaching, from a picker configured to perform the automatic picking, a picker clamp configured to clamp substrates; and
parking the detached picker clamp on the substrate clamp carrier.

14. The method of claim 12 or 13, comprising, before picking the replacement substrate clamp:
detaching from the support stage a substrate clamp to be replaced; and
parking the detached substrate clamp on the substrate clamp carrier.

15. The method of any of claims 12-14, comprising:
detaching from the support stage a calibration substrate to be replaced, the calibration substrate comprising a structure for calibrating a measurement sensor; and
parking the detached calibration substrate on the substrate clamp carrier.

16. A method for bonding substrates to substrates, the method comprising the method of any of claims 12-15.
